(19) **Europäisches Patentamt / European Patent Office / Office européen des brevets**

(11) **EP 1 856 739 B1**

(12) **EUROPÄISCHE PATENTSCHRIFT**

(45) Veröffentlichungstag und Bekanntmachung des Hinweises auf die Patenterteilung:
**01.02.2012 Patentblatt 2012/05**

(21) Anmeldenummer: **05733301.5**

(22) Anmeldetag: **10.03.2005**

(51) Int Cl.:
**H01L 23/50** (2006.01)

(86) Internationale Anmeldenummer:
**PCT/DE2005/000433**

(87) Internationale Veröffentlichungsnummer:
**WO 2006/094469 (14.09.2006 Gazette 2006/37)**

(54) **EINRICHTUNG ZUR ENERGIEVERSORGUNG EINES INTEGRIERTEN SCHALTKREISES**

DEVICE FOR SUPPLYING AN INTEGRATED CIRCUIT WITH POWER

DISPOSITIF D'ALIMENTATION D'UN CIRCUIT INTEGRE

(84) Benannte Vertragsstaaten:
**DE FR**

(43) Veröffentlichungstag der Anmeldung:
**21.11.2007 Patentblatt 2007/47**

(73) Patentinhaber: **Conti Temic microelectronic GmbH**
**90411 Nürnberg (DE)**

(72) Erfinder: **SCHUBERT, Göran**
**91126 Schwabach (DE)**

(56) Entgegenhaltungen:
**WO-A-03/012870     US-A- 5 616 952**

**Beschreibung**

Die Erfindung betrifft eine Einrichtung zur Energieversorgung eines schnell taktenden und/oder schnell getakteten integrierten Schaltkreises, der eine zu versorgende Schaltkreislast und eine zur Schaltkreislast parallel geschaltete interne Kapazität aufweist.

Wie in anderen Bereichen der Technik finden heutzutage auch im Bereich der Automobiltechnik zunehmend integrierte Schaltkreise, beispielsweise in Form von Mikroprozessoren oder Mikrocontrollern, Verwendung. Zu deren Betrieb sind Einrichtungen zur Energieversorgung vorgesehen. Bekannte derartige Einrichtungen enthalten üblicherweise eine parallel zwischen einen Versorgungseingang des integrierten Schaltkreises und Masse geschaltete externe Abblockkapazität sowie eine parallel dazu geschaltete Spannungsquelle. (z.B. das Dokument WO 03/012870). Die Spannungsquelle lädt die Abblockkapazität, und die dem integrierten Schaltkreis zugeführte Energie wird der Abblockkapazität mittels eines Entladestroms entzogen. Dadurch soll eine möglichst realistische Nachbildung einer idealen Spannungsquelle erreicht werden. Die bekannten Einrichtungen zur Energieversorgung führen allerdings zu einer unerwünscht hohen Abstrahlung von elektromagnetischer Energie, insbesondere wenn eine Taktfrequenz des integrierten Schaltkreises größere Werte als 10 MHz annimmt. Dann werden gegebenenfalls auch die EMV-Anforderungen der Automobil-Branche nicht mehr erfüllt.

Die Aufgabe der Erfindung besteht deshalb darin, eine Einrichtung der eingangs bezeichneten Art anzugeben, mit deren Hilfe ein integrierter Schaltkreis auch bei einer hohen Taktrate, insbesondere im MHz-Bereich, mit Energie versorgt werden kann, wobei gleichzeitig die EMV-Anforderungen der Automobil-Branche eingehalten werden.

Zur Lösung dieser Aufgabe wird eine Einrichtung zur Energieversorgung eines schnell taktenden integrierten Schaltkreises entsprechend den Merkmalen des Patentanspruchs 1 angegeben. Die Erfindung beruht dabei im Wesentlichen auf zwei Maßnahmen. Zum einen wird auf die externe Beschaltung mit der zusätzlichen Abblockkapazität verzichtet. Stattdessen wird eine innerhalb des integrierten Schaltkreises ohnehin vorhandene interne Buskapazität verwendet. Zum anderen wird anstelle der bei den bekannten Einrichtungen eingesetzten niederohmigen Spannungsquelle eine Energieversorgung mit einem möglichst hohen Innenwiderstand verwendet.

Die Kombination beider Maßnahmen bewirkt eine Frequenzentkopplung der Auf- und der Entladung der Buskapazität. Während das Entladen der Buskapazität weiterhin mit der hohen Taktfrequenz stattfindet, erfolgt das Aufladen dagegen bei einer deutlich tieferen Frequenz. Letztere ergibt sich aufgrund des Tiefpassverhaltens der Kombination von Buskapazität und hochohmigem Innenwiderstand der Versorgungseinheit. Im Zusammenhang mit der Aufladung auftretende Ladefrequenzen sind um mindestens eine Größenordnung kleiner als im Zusammenhang mit der Entladung auftretende Entladefrequenzen, die hauptsächlich durch die Grundwelle (= Taktfrequenz) der Taktrate des integrierten Schaltkreises und deren Oberwellen bestimmt werden. Nebenstörungen entstehen durch die interne Kommunikation, deren Grundfrequenz meist mit der halben Taktrate betrieben wird. Signalanteile mit den hochfrequenten Entladefrequenzen sind räumlich eng begrenzt und liegen im Wesentlichen nur innerhalb des integrierten Schaltkreises vor. Signalanteile mit den niederfrequenten Ladefrequenzen durchlaufen dagegen auch eine Leiterplatte, auf die der integrierte Schaltkreis montiert ist. Beide Signalanteile bewirken keine wesentliche Abstrahlung von elektromagnetischer Energie - der Entlade-Signalanteil aufgrund der engen räumlichen Begrenzung innerhalb des integrierten Schaltkreises und der Lade-Signalanteil aufgrund der niedrigen Frequenz.

Insgesamt lässt sich also auch ein integrierter Schaltkreis mit einer hohen Taktrate mittels der erfindungsgemäßen Einrichtung mit elektrischer Energie versorgen, ohne dass es dabei zu einer nennenswerten Abstrahlung elektromagnetischer Energie kommt. Die EMV-Anforderungen der Automobil-Branche werden auch bei Taktfrequenzen im oberen MHz-Bereich noch eingehalten.

Vorteilhafte Ausgestaltungen der erfindungsgemäßen Einrichtung ergeben sich aus den von Anspruch 1 abhängigen Ansprüchen.

Die Variante nach Anspruch 2 lässt sich einfach realisieren. Eine Stromquelle, die im Idealfall durch einen un-endlich hohen Innenwiderstand gekennzeichnet ist, wird mittels einer Reihenschaltung einer niederohmigen Spannungsquelle mit dem je nach Anwendungsfall dimensionierten Innenwiderstand nachgebildet. Eine Spannungsquelle kann in einfacher Weise aufgebaut werden. Dies gilt insbesondere auch für eine spannungsgesteuerte Spannungsquelle.

Die Ausgestaltung gemäß Anspruch 3 stellt sicher, dass die Energiezuführung dem aktuell herrschenden Bedarf entspricht.

Dabei gewährleistet die Maßnahme nach Anspruch 4 außerdem, dass die Regeleinheit eine vorteilhaft niedrige Regelungsgeschwindigkeit aufweist. Auch abrupte Änderungen der an der internen Kapazität abfallenden Spannung führen aufgrund der Tiefpass-Wirkung nur zu einem langsamen Nachführen von Ladeenergie.

Die Variante gemäß Anspruch 5 verhindert, dass hochfrequente Signalanteile in nennenswertem Umfang auch außerhalb des integrierten Schaltkreises, also beispielsweise auf den Zu-/Ableitungen der Leitplatte, auftreten und dort zu einer Abstrahlung führen.

Die Maßnahme gemäß Anspruch 6 verhindert einen zu starken Einfluss von Parallelkapazitäten der zur Realisierung des Innenwiderstandes eingesetzten Einzelelemente. Parallelkapazitäten sind ungünstig, da sie bei hohen Frequenzen einen niedrigen Impedanzwert aufweisen. Die Reihenschaltung eines Widerstands und eines Ferrit-Elements reduziert den unerwünschten Einfluss der Parallelkapazität des Ferrit-Elements. Ebenso verringert sich der Einfluss der parasitären Parallelkapazität des Widerstands, wenn mehrere Widerstände in Reihe geschaltet sind. Einen guten Kompromiss zwischen Aufwand und Nutzen liefert insbesondere die Reihenschaltung von vier niederkapazitiven Widerständen. Der mindestens eine niederkapazitive Widerstand reduziert die Überbrückungskapazität der Gesamtanordnung und liefert eine wirksame Grunddämpfung, wohingegen das Ferrit-Element gerade im Bereich der hohen Taktfrequenz einen erwünscht hohen Verlustanteil aufweist. Die vorstehend genannten vorteilhaften Weiterbildungen können in beliebigen Kombinationen vorliegen.

Weitere Merkmale, Vorteile und Einzelheiten der Erfindung ergeben sich aus der nachfolgenden Beschreibung von Ausführungsbeispielen anhand der Zeichnung. Es zeigen:

Fig. 1 und 2    eine Einrichtung zur Energieversorgung eines Schaltkreises gemäß dem Stand der Technik,

Fig. 3 und 4    ein Ausführungsbeispiel einer erfindungsgemäßen Einrichtung zur Energieversorgung eines Schaltkreises,

Fig. 5    ein Blockschaltbild für eine Regelung der Energieversorgung gemäß den Fig. 3 und 4,

Fig. 6    ein Ausführungsbeispiel einer erfindungsgemäßen Einrichtung zur geregelten Energieversorgung eines Schaltkreises und

Fig. 7    ein Ausführungsbeispiel eines Innenwiderstands der Energieversorgung gemäß Fig. 6.

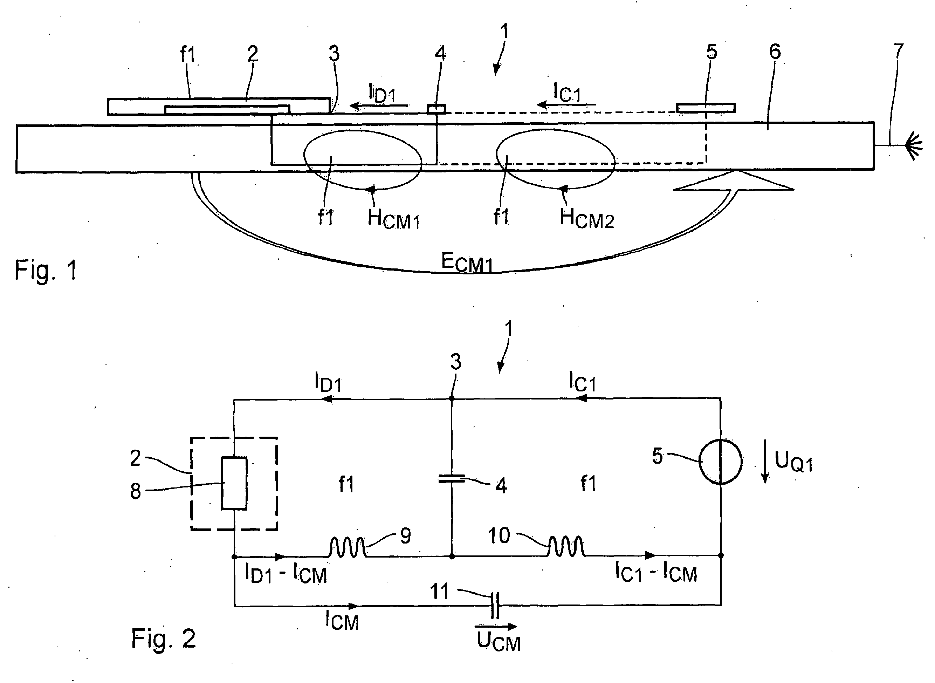

Einander entsprechende Teile sind in den Fig. 1 bis 7 mit denselben Bezugszeichen versehen.

In Fig. 1 und 2 ist eine Einrichtung 1 zur Energieversorgung eines integrierten Schaltkreises 2 gemäß dem Stand der Technik dargestellt. Ein Versorgungseingang 3 des integrierten Schaltkreises 2 ist parallel mit einer externen Abblockkapazität 4 und einer als Spannungsquelle ausgebildeten Versorgungseinheit 5 beschaltet. Der integrierte Schaltkreis 2, die Abblockkapazität 4 und die Versorgungseinheit 5 sind auf einer zweilagigen Leiterplatte 6, an die ein Kabelbaum 7 angeschlossen ist, angeordnet. In dem Ersatzschaltbild nach Fig. 2 ist der beispielsweise als schnell taktender Mikroprozessor oder Mikrocontroller oder auch als schnell getakteter Speicherbaustein ausgeführte integrierte Schaltkreis 2 als komplexe Impedanz 8 wiedergegeben. Außerdem sind in der Masse-Rückleitung zwei Common-Mode-Induktivitäten 9 und 10 angeordnet, denen eine Antennendach-Kapazität 11 parallel geschaltet ist.

Die bekannte Einrichtung 1 zur Energieversorgung hat folgende Wirkungsweise. Die Versorgungseinheit 5 liefert eine Quellspannung $U_{Q1}$. Mittels der parallelgeschalteten Abblockkapazität 4, die beispielsweise einen Kapazitätswert von etwa 100 nF hat, wird eine ideale Spannungsquelle nachgebildet. Die Energieversorgungseinheit 5 liefert einen Ladestrom $I_{C1}$, mittels dessen die Abblockkapazität 4 aufgeladen wird. Ein der Abblockkapazität 4 entnommener Entladestrom $I_{D1}$ versorgt den integrierten Schaltkreis 2 mit Energie. Der Ladestromkreis ist in Fig. 1 mit gestrichelten Linien und der Entladestromkreis mit durchgezogenen Linien angedeutet. Bei jedem Schaltvorgang des integrierten Schaltkreises 2 wird der Abblockkapazität 4 also ein Teil ihrer Ladung entnommen. Die dadurch entstehende Potentialdifferenz wird durch sofortiges Nachladen mittels der Energievorsorgungseinheit 5 wieder ausgeglichen.

Der Ladestrom $I_{C1}$ und der Entladestrom $I_{D1}$ enthalten dieselben Frequenzanteile, die im Wesentlichen durch den schnell getakteten integrierten Schaltkreis 2, insbesondere durch dessen Taktfrequenz f1, bestimmt werden. Folglich ergeben sich die Magnetfelder $H_{CM1}$ und $H_{CM2}$, die als konzentrierte Elemente den Common-Mode-Induktivitäten 9 bzw. 10 (Fig. 2) in den Zu-/Rückleitungen des Lade- und des Entladestromkreises symbolisiert sind und Spannungsabfälle mit der gleichen hohen Taktfrequenz f1 hervorrufen. Innerhalb der Zu-/Rückleitungen der Leiterplatte 6 bildet sich also eine Common-Mode-Spannung $U_{CM}$ aus, die mit einem elektrischen Feld $E_{CM1}$ (Fig.1) verknüpft ist und die aufgrund der Energiespeichereigenschaft der Induktivitäten 9 und 10 (Fig.2) einen Common-Mode-Strom $I_{CM}$ treibt.

Im Rahmen der Erfindung wurde erkannt, dass die Gesamtanordnung aus Leiterplatte 6 und Kabelbaum 7 ein dipolartiges Antennenverhalten aufweist. Der Common-Mode-Strom $I_{CM}$ wird daher zumindest zu einem gewissen Anteil abgestrahlt. Der Grad der Abstrahlung hängt dabei stark von der Taktfrequenz f1 ab. Aufgrund des dipolartigen Verhaltens steigt die Abstrahlung mit dem Quadrat der Taktfrequenz f1. Eine hohe, beispielsweise im n x 10 MHz-Bereich angesiedelte Taktfrequenz f1 führt somit zu einer sehr hohen Abstrahlung. Die abgestrahlte Energie stammt dabei größtenteils aus dem Verschiebungsstrom der Antennendach-Kapazität 11 (Fig. 2), also aus dem Common-Mode-Strom $I_{CM}$.

Das beschriebene Abstrahlverhalten der bekannten Einrichtung 1 führt dazu, dass EMV-Anforderungen, die insbesondere bei einem Einsatz der Einrichtung 1 in der Automobiltechnik vorgegeben sind, bei steigenden Taktfrequenzen f1 nicht mehr erfüllt werden können.

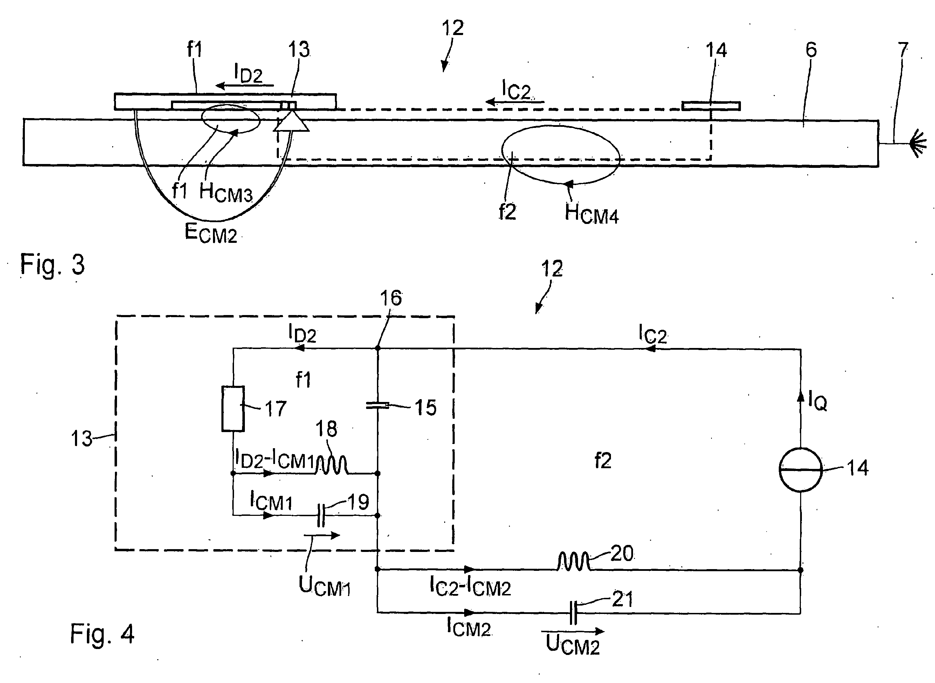

Die in den Fig. 3 bis 7 gezeigten Ausführungsbeispiele erfindungsgemäßer Einrichtungen zur Energieversorgung umgehen die beschriebenen Nachteile der bekannten Einrichtung 1. Sie weisen ein stark reduziertes Abstrahlverhalten auf, sodass die von der Automobil-Branche gestellten EMV-Anforderungen auch bei einer hohen Taktfrequenz f1 erfüllt werden.

In den Fig. 3 und 4 ist ein erstes Ausführungsbeispiel einer erfindungsgemäßen Einrichtung 12 zur Energieversorgung eines integrierten Schaltkreises 13 mittels einer Versorgungseinheit 14 dargestellt. Im Unterschied zur Einrichtung 1 enthält die Einrichtung 12 keine gesonderte externe Abblockkapazität 4. Stattdessen wird auf eine interne Buskapazität 15 zurückgegriffen, die als Bestandteil eines Versorgungsbusses des integrierten Schaltkreises 13 parallel zu einem Versorgungseingang 16 angeordnet ist und beispielsweise einen Kapazitätswert von etwa 5 nF hat. Durch den Rückgriff auf die ohnehin vorhandene Buskapazität 15 sinkt der Realisierungsaufwand. Außerdem ist die Versorgungseinheit 14 nicht wie bei der Einrichtung 1 als niederohmige Spannungsquelle, sondern als hochohmige Stromquelle ausgebildet.

Gemäß Fig. 4 enthält der integrierte Schaltkreis 13 neben der Buskapazität 15 sowie einer eigentlich zu versorgenden und als Impedanz symbolisierten Schaltkreislast 17 in seiner Masse-Rückleitung eine Common-Mode-Induktivität 18 und eine dazu parallel angeordnete Antennendach-Kapazität 19. Dementsprechend weist auch der im Wesentlichen über die Leiterplatte 6 verlaufende Ladestromkreis in seiner Masse-Rückleitung eine Parallelschaltung aus einer Common-Mode-Induktivität 20 und einer Antennendach-Kapazität 21 auf.

Im Folgenden wird die Wirkungsweise der erfindungsgemäßen Einrichtung 12 näher beschrieben. Der Ladestromkreis und der Entladestromkreis sind sowohl räumlich als auch in der Frequenz entkoppelt. Der Entladestromkreis ist auf die Fläche des integrierten Schaltkreises 13 begrenzt, wohingegen der Ladestromkreis im Wesentlichen in der Leiterplatte 6 verläuft. Ein Entladestrom $I_{D2}$, mittels dessen der Buskapazität 15 Energie entnommen und der Schaltkreislast 17 zugeführt wird, weist Frequenzanteile auf, die im Wesentlichen durch die hohe Taktfrequenz f1 bestimmt sind. Dagegen erfolgt die Ladung der Buskapazität 15 mittels eines Ladestroms $I_{C2}$, der eine wesentlich niedrigere Ladefrequenz f2 aufweist und als Quellstrom $I_Q$ von der Versorgungseinheit 14 zur Verfügung gestellt wird.

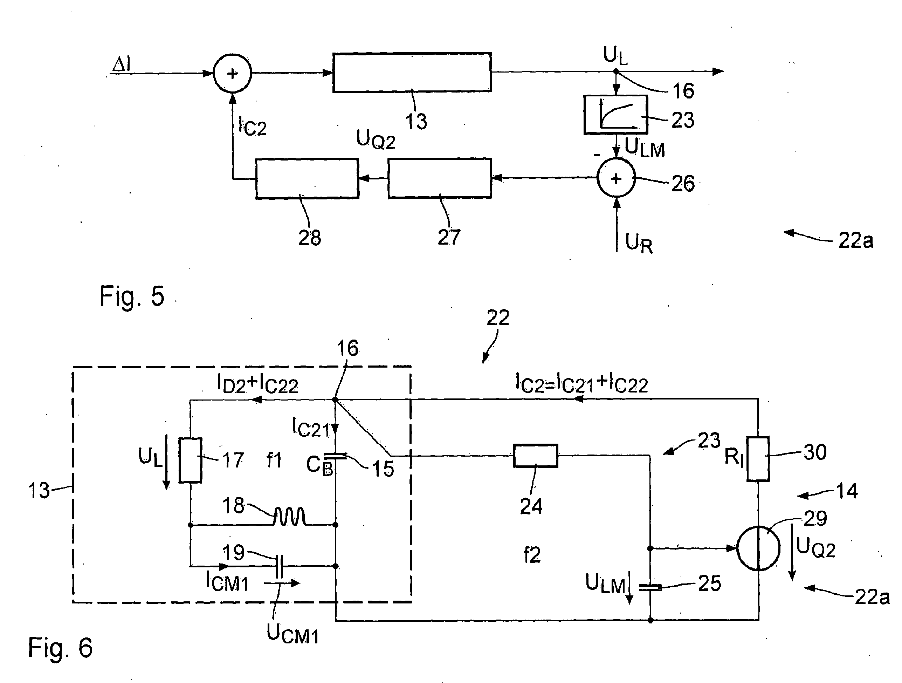

Die Buskapazität 15 und der hochohmige Innenwiderstand der Versorgungseinheit 14 bilden einen Tiefpass, der die wesentlich niedrigeren Frequenzen des Ladestroms $I_{C2}$ bedingt. Im Idealfall eines unendlich hohen Innenwiderstands enthält der Ladestrom $I_{C2}$ ausschließlich einen Gleichanteil. Aber auch bei einer praktischen Realisierung liegt die Ladefrequenz f2 mindestens um eine Größenordnung niedriger als die Taktfrequenz f1. Typischerweise bewegt sich die Ladefrequenz f2 im kHz-Bereich und die Taktfrequenz f1 zwischen 50 MHz und 300 MHz. Bei einer so niedrigen Ladefrequenz f2 führt ein mit dem Ladestrom $I_{C2}$ verknüpftes Magnetfeld $H_{CM4}$ zu einer proportional zur Frequenzverringerung geringeren Common-Mode-Spannung $U_{CM2}$. Die Effektivität des dipolartigen Gebildes der Gesamtanordung sinkt sogar mit dem Quadrat der Frequenzverringerung von f1 verglichen mit f2, sodass sich - wenn überhaupt - ein nur sehr niedriger Common-Mode-Strom $I_{CM2}$ innerhalb der Leiterplatte 6 ausbildet, und keine nennenswerte Abstrahlung stattfindet. Deshalb sind die Common-Mode-Induktivität 20 und die Antennendach-Kapazität 21 in der Darstellung der folgenden Fig. 6 weggelassen. Innerhalb des integrierten Schaltkreises 13 führt ein mit dem Entladestrom $I_{D2}$ einhergehendes Magnetfeld $H_{CM3}$ aufgrund der höheren Frequenzanteile zur Ausbildung eines elektrischen Feldes $E_{CM2}$ und einer Common-Mode-Spannung $U_{CM1}$. Dementsprechend bildet sich in der Masse-Rückleitung auch ein Common-Mode-Strom $I_{CM1}$ aus. Da die vom Strom $I_{D2}$ umrandete Fläche des integrierten Schaltkreises 13 deutlich kleiner ist als die bei der Einrichtung 1 durch $I_{D1}$ umfasste Fläche der Leiterplatte 6, resultiert verglichen mit der Einrichtung 1 eine deutlich reduzierte Abstrahlung. Eine ideale Versorgungseinheit 14 vorausgesetzt liefert eine vergleichende Abschätzung der bei den Einrichtungen 1 und 12 jeweils erfassten, d.h. von den hochfrequenten Strömen $I_{C1}$ und $I_{D1}$ bzw. $I_{D2}$ umrandeten Flächen eine Reduzierung der Abstrahlung um einen Faktor von etwa 10000.

In Fig. 5 ist ein Blockschaltbild für eine Regelung der Energieversorgung der Einrichtung 13 dargestellt. Eine Umsetzung dieses Regelungskonzepts ist in einem weiteren in Fig. 6 gezeigten Ausführungsbeispiel einer Einrichtung 22 zur Energieversorgung des integrierten Schaltkreises 13 enthalten. Die Regelung stellt sicher, dass der Schaltkreislast 17 eine konstante Lastspannung $U_L$ zur Energieversorgung zur Verfügung gestellt wird. Da es im Wesentlichen nur darauf ankommt, den Mittelwert der an der Buskapazität 15 abfallenden Spannung konstant zu halten, kann die Lastspannung $U_L$ direkt am Versorgungseingang 16 abgegriffen werden, wobei sowohl die Common-Mode-Induktivität 18 als auch ggf. zusätzlich vorhandene Bond-Induktivitäten vernachlässigt werden können.

Eine Regeleinheit 22a umfasst einen am Versorgungseingang 16 angeschlossenen Tiefpass 23, der mittels eines Tiefpass-Widerstands 24 und einer Tiefpass-Kapazität 25 aufgebaut ist, eine Vergleichsstelle 26, einen Regler 27 sowie einen U/I-Wandler 28. Bei dem Ausführungsbeispiel gemäß Fig. 6 sind die Vergleichsstelle 26 und der Regler 27 in eine spannungsgesteuerte Spannungsquelle 29 integriert. Der U/I-Wandler 28 ist als ein insbesondere im Bereich der Taktfrequenz f1 hochohmiger Innenwiderstand 30 realisiert. Die Reihenschaltung der Spannungsquelle 29 und des hochohmigen Innenwiderstands 30 bildet die als Bestandteil der Regelungseinheit 22a ausgeführte Versorgungseinheit 14. Diese Reihenschaltung stellt eine Nachbildung einer Stromquelle dar.

Unter Bezugnahme auf die Fig. 5 und 6 wird im Folgenden die Funktionsweise der bei der Einrichtung 22 eingesetzten geregelten Energieversorgung beschrieben. Die in erster Näherung auch am Versorgungseingang 16 anstehende Lastspannung $U_L$ wird an der Tiefpass-Kapazität 25 als gemessene Lastspannung $U_{LM}$ erfasst und der in die Spannungsquelle 29 integrierten Vergleichsstelle 26 zugeführt. Je nach Abweichung von einer vorgegebenen Referenzspannung $U_R$ wird der Regler 27 angesteuert, sodass an seinem Ausgang und damit auch am Ausgang der Spannungsquelle 29 eine Quellspannung $U_{Q2}$ ansteht. Letztere wird mittels des hochohmigen Innenwiderstands 30 in den Ladestrom $I_{C2}$ umgewandelt, der dem integrierten Schaltkreis 13 zur Energieversorgung zugeführt wird. Abweichungen, die sich aufgrund von Lastschwankungen oder anderen zufälligen Ereignissen ergeben, werden in dem Blockschaltbild gemäß Fig. 5 durch eine Beaufschlagung des Ladestroms $I_{C2}$ mit einer Störgröße $\Delta I$ berücksichtigt.

Durch entsprechende Dimensionierung des Tiefpasses 23 wird die Regelungsgeschwindigkeit begrenzt, sodass die Transitfrequenz der Regelung kleiner als die Grundwelle (= Taktfrequenz f1) der Taktung des Schaltkreises 13 ist. Insbesondere liegt diese Transitfrequenz mindestens um eine Größenordnung unter der Taktfrequenz f1. Bei einer Taktfrequenz f1 von beispielsweise 50 MHz ist die höchste Frequenz, die die Regelung dann typischerweise verursacht oder passieren lässt, kleiner oder gleich 1 MHz. Dadurch wird sichergestellt, dass praktisch keine für eine Abstrahlung relevanten hochfrequenten Signalanteile in der Leiterplatte 6 auftreten.

Exakt gilt die letzte Aussage nur bei einem unendlichen Innenwiderstand 30. In der Praxis weist der Innenwiderstand 30 jedoch einen endlichen Wert auf, sodass sich der Ladestrom $I_{C2}$ aus einem ersten niederfrequenten Ladestromanteil $I_{C21}$ und einem zweiten hochfrequenten Ladestromanteil $I_{C22}$ zusammensetzt. Der erste Ladestromanteil $I_{C2}$, dient zur Aufladung der Buskapazität 15 und der zweite Ladestromanteil $I_{C22}$ wird zusammen mit dem ebenfalls hochfrequenten Entladestrom $I_{D2}$ der Schaltkreislast 17 zur Energieversorgung zugeführt. Hierbei ist der der internen Buskapazität 15 entzogene Ladestrom $I_{D2}$ deutlich größer als der dem Ladestromkreis entzogene hochfrequente zweite Ladestromanteil $I_{C22}$. Eine entsprechende Dämpfung a(f) ergibt sich zu:

$$a(f) = \left| \frac{I_{C22}}{I_{D2}} \right| = \left| \frac{1}{j2\pi f R_I C_B} \right|,$$

wobei mit $R_I$ der Wert des Innenwiderstands 30, mit $C_B$ der Wert der Buskapazität 15 und mit f die Frequenz bezeichnet ist. Hierbei ist vorausgesetzt, dass der Innenwiderstand 30 idealisiert als rein ohmscher Widerstand dargestellt werden kann. Bei einer genaueren Betrachtung sollte jedoch die parasitäre Parallelkapazität mitberücksichtigt werden.

Die Parallelkapazität ist unerwünscht, da sie insbesondere bei hohen Frequenzen eine niederohmige Überbrückung des ohmschen Anteils des Innenwiderstands 30 darstellt. Um diesen Einfluss zu minimieren, wird der Innenwiderstand 30 vorzugsweise mittels einer Reihenschaltung mehrerer Widerstände realisiert.

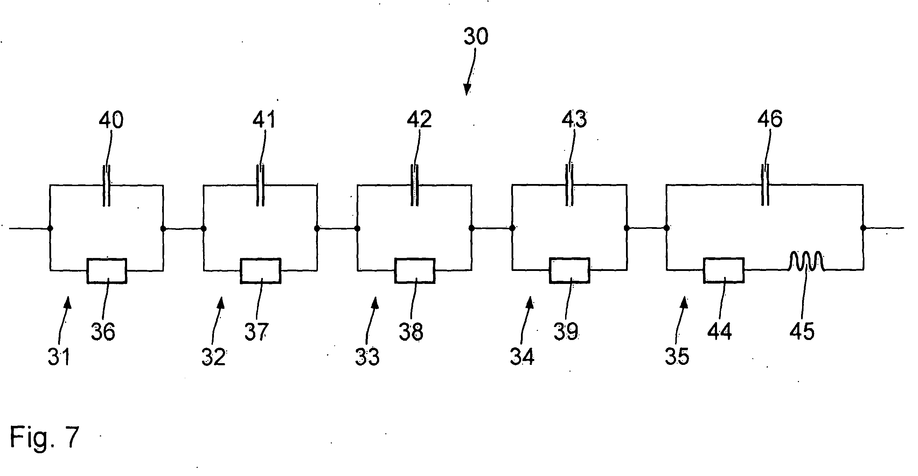

In Fig. 7 ist ein entsprechendes Ausführungsbeispiel des Innenwiderstands 30 gezeigt. Er enthält eine Reihenschaltung aus insgesamt vier niederkapazitiven Teil-Widerständen 31, 32, 33 und 34 und einem Ferrit-Element 35. Die Teil-Widerstände 31 bis 34 haben jeweils einen ohmschen Widerstand 36, 37, 38 bzw. 39 und eine Parallelkapazität 40, 41, 42 bzw. 43. Je höher die Anzahl der in Reihe geschalteten Teil-Widerstände 31 bis 34 ist, desto niedriger wird der unerwünschte Einfluss der parasitären Parallelkapazitäten 40 bis 43, die beispielsweise einen Wert von kleiner als 0,5 pF haben. Bei insgesamt vier in Reihe geschalteten Teil-Widerständen 31 bis 34 ergibt sich ein guter Kompromiss zwischen Aufwand und Nutzen.

Das ebenfalls in der Reihenschaltung des Innenwiderstands 30 enthaltene Ferrit-Element 35 umfasst eine Reihenschaltung aus einem Ferrit-Widerstand 44 und einer Ferrit-Induktivität 45 und eine parallel dazu angeordnete Ferrit-Kapazität 46. Die in Reihe zum Ferrit-Element 35 geschalteten Teil-Widerstände 31 bis 34 reduzieren auch den Einfluss der parallelliegenden Ferrit-Kapazität 46.

Während der Gleichstromwiderstand des Ferrit-Elements 35 bei praktisch Null Ohm liegt, verursacht insbesondere der ohmsche Anteil der Ferrit-Induktivität 45 bei hohen Frequenzen, also vor allem bei der Trägerfrequenz f1 und ihren Oberwellen, einen erwünscht hohen Verlustwiderstand im kΩ-Bereich und entnimmt dem elektrischen Kreis hochfrequente Energie durch Wandlung in Wärmeenergie. Die ohmschen Widerstände 36 bis 39 haben einen Gesamtwert von etwa 100 Ω. Sie reduzieren die Überbrückungskapazität der Gesamtanordnung und liefern eine wirksame Grunddämpfung. Der Innenwiderstand 30 gemäß Fig. 7 hat also einen frequenzabhängigen Gesamt-Impedanzwert, der insbesondere mit steigender Frequenz zunimmt.

Die Teil-Widerstände 31 bis 34 reduzieren die überbrückende Ferrit-Kapazität 46 auf etwa den 1/24ten Teil ihres ursprünglichen Wertes. Außerdem erhöhen sie die Resonanzfrequenz der Gesamtanordnung aus der Einrichtung 22, der Leiterplatte 6 und dem Kabelbaum 7 etwa auf die 5fache Frequenz.

Bei der Dimensionierung des Innenwiderstands 30 wird eine Abwägung zwischen größtmöglichem ohmschen Widerstandswert $R_I$ und mit noch vertretbarem Aufwand realisierbarem Wert der Quellspannung $U_{Q2}$ vorgenommen. Mit steigendem Widerstand $R_I$ wird nämlich auch eine höhere Quellspannung $U_{Q2}$ benötigt, um den Ladestrom $I_{C2}$ mit der erforderlichen Stromstärke, die typischerweise im n x 100 mA-Bereich liegen kann, zu erhalten. Der beispielsweise als Auf/Abwärts-Schaltregler ausgebildete Regler 27 ist für eine gemessene Lastspannung $U_{LM}$ und für eine Quellspannung $U_{Q2}$ ausgelegt, deren Werte sich typischerweise im Bereich einiger Volt bis einiger 10 Volt bewegen. Der Innenwiderstand 30 ist aber stets so dimensioniert, dass sein Impedanzwert bei der Taktfrequenz f1 so hoch ist, dass ein die Schaltkreislast 17 versorgender hochfrequenter Strom zu einem größeren Anteil aus der Buskapazität 15 als aus der Versorgungseinheit 14 stammt.

**Patentansprüche**

1. Einrichtung zur Energieversorgung eines schnell taktenden und/oder schnell getakteten integrierten Schaltkreises (13; 51; 52), der eine zu versorgende Schaltkreislast (17) und eine zur Schaltkreislast (17) parallel geschaltete interne Kapazität (15) aufweist, wobei

   a) der integrierte Schaltkreis (13; 51; 52) eine hohe, mindestens im MHz-Bereich liegende Taktfrequenz (f1) aufweist,
   b) eine als Stromquelle ausgebildete Versorgungseinheit (14; 56; 61) direkt an die interne Kapazität (15) angeschlossen ist, dadurch gekenzeichnet, dass
   c) die Versorgungseinheit (14; 56; 61) einen Innenwiderstand (30) hat, dessen Impedanzwert bei der Taktfrequenz (f1) und ihren Oberwellen so hoch ist, dass ein die Schaltkreislast (17) versorgender Strom ($I_{D2}$, $I_{C22}$) zu einem größeren Anteil aus der internen Kapazität (15) als aus der Versorgungseinheit (14; 56; 61) stammt.

2. Einrichtung nach Anspruch 1, **dadurch gekennzeichnet, dass** die Versorgungseinheit (14; 56; 61) eine als Stromquelle wirkende Reihenschaltung aus einer Spannungsquelle (29) und dem Innenwiderstand (30) umfasst.

3. Einrichtung nach Anspruch 1, **dadurch gekennzeichnet, dass** eine Regeleinheit (22a) zur Regelung der von der Versorgungseinheit (14; 56; 61) dem integrierten Schaltkreis (13; 51; 52) zur Verfügung gestellten Energie vorgesehen ist.

4. Einrichtung nach Anspruch 3, **dadurch gekennzeichnet, dass** die Regeleinheit (22a) einen an die interne Kapazität (15) angeschlossenen Tiefpass (23) zur Erfassung einer an der Schaltkreislast (17) abfallenden Spannung ($U_L$, $U_{LM}$) umfasst.

5. Einrichtung nach Anspruch 1, **dadurch gekennzeichnet, dass** die Versorgung mittels der Versorgungseinheit (14; 56; 61) ein Tiefpass-Verhalten mit einer Transitfrequenz aufweist, die niedriger als die Taktfrequenz (f1) ist.

6. Einrichtung nach Anspruch 1, **dadurch gekennzeichnet, dass** der Innenwiderstand (30) mindestens einen niederkapazitiven Widerstand (31, 32, 33, 34) und ein in Reihe geschaltetes Ferrit-Element (35) umfasst.

**Claims**

1. Device for supplying an integrated circuit (13; 51; 52) with power, said integrated circuit clocking at a high speed and/or being clocked at a high speed, said integrated circuit having a circuit load (17) that is to be supplied with power and an internal capacitor (15) that is connected in parallel with the circuit load (17), wherein

   a) the integrated circuit (13; 51; 52) has a high clock frequency (f1) that is at least in the MHz range,
   b) a supply unit (14; 56; 61) configured as a current source is connected directly to the internal capacitor (15), **characterized in that**
   c) the supply unit (14; 56; 61) has an internal resistor (30) whose impedance value at the clock frequency (f1) and at its harmonics is so high that a current ($I_{D2}$, $I_{C22}$) supplying the circuit load (17) with power originates to a greater proportion from the internal capacitor (15) than from the supply unit (14; 56; 61).

2. Device according to claim 1, **characterized in that** the supply unit (14; 56; 61) comprises a series connection that is composed of a voltage source (29) and the internal resistor (30), said series connection acting as a current source.

3. Device according to claim 1, **characterized in that** a control unit (22a) is provided that controls the power that is supplied to the integrated circuit (13; 51; 52) by the supply unit (14; 56; 61).

4. Device according to claim 3, **characterized in that** the control unit (22a) comprises a low-pass filter (23) for detecting a voltage ($U_L$, $U_{LM}$) dropping at the circuit load (17), said low-pass filter being connected to the internal capacitor (15).

5. Device according to claim 1, **characterized in that** the supply by means of the supply unit (14; 56; 61) shows a low-pass behavior with a transition frequency that is lower than the clock frequency (f1).

6. Device according to claim 1, **characterized in that** the internal resistor (30) comprises at least one low-capacitance resistor (31, 32, 33, 34) and a ferrite element (35) that is connected in series.

**Revendications**

1.  Equipement pour l'alimentation en énergie d'un circuit intégré (13 ; 51 ; 52) fournissant une cadence rapide et/ou à cadence rapide, qui présente une charge de circuit électrique (17) à alimenter et une capacité interne (15) montée en parallèle avec la charge de circuit électrique (17),

    a) le circuit intégré (13 ; 51 ; 52) présentant une fréquence d'horloge (f1) élevée, située au moins dans la plage des MHz,
    b) une unité d'alimentation (14 ; 56 ; 61) constituée en tant que source de courant étant connectée directement à la capacité interne (15), **caractérisé en ce que**
    c) l'unité d'alimentation (14 ; 56 ; 61) a une résistance interne (30) dont la valeur d'impédance, à la fréquence d'horloge (f1) et au niveau de ses harmoniques, est élevée au point qu'un courant ($I_{D2}$, $I_{C22}$) alimentant la charge de circuit électrique (17) provient davantage de la capacité interne (15) que de l'unité d'alimentation (14 ; 56 ; 61).

2.  Equipement selon la revendication 1, **caractérisé en ce que** l'unité d'alimentation (14 ; 56 ; 61) comprend un montage en série agissant en tant que source de courant et composé d'une source de tension (29) et de la résistance interne (30).

3.  Equipement selon la revendication 1, **caractérisé en ce qu'**il est prévu une unité de régulation (22a) pour la régulation de l'énergie mise à la disposition du circuit intégré (13 ; 51 ; 52) par l'unité d'alimentation (14 ; 56 ; 61).

4.  Equipement selon la revendication 3, **caractérisé en ce que** l'unité de régulation (22a) comprend un filtre passe-bas (23) raccordé à la capacité interne (15) pour la détection d'une tension ($U_L$, $U_{LM}$) diminuant au niveau de la charge de circuit électrique (17).

5.  Equipement selon la revendication 1, **caractérisé en ce que** l'alimentation présente, au moyen de l'unité d'alimentation (14 ; 56 ; 61), un comportement de filtre passe-bas avec une fréquence de transition qui est plus faible que la fréquence d'horloge (f1).

6.  Equipement selon la revendication 1, **caractérisé en ce que** la résistance interne (30) comprend au moins une résistance à faible capacité (31, 32, 33, 34) et un élément de ferrite (35) monté en série.

EP 1 856 739 B1

Fig. 1

f1  2  3  4  1  5  6  7

$I_{D1}$  $I_{C1}$

f1  $H_{CM1}$  f1  $H_{CM2}$

$E_{CM1}$

Fig. 2

1

3

$I_{D1}$  $I_{C1}$

2  5  $U_{Q1}$

8  f1  4  f1

9  10

$I_{D1} - I_{CM}$  $I_{C1} - I_{CM}$

11

$I_{CM}$

$U_{CM}$

Fig. 3

Fig. 4

EP 1 856 739 B1

EP 1 856 739 B1

$\Delta I$

$I_{C2}$

$U_{Q2}$

13

16

$U_L$

23

$U_{LM}$

26

$U_R$

28          27

22a

Fig. 5

22

16

$I_{D2}+I_{C22}$

$I_{C2}=I_{C21}+I_{C22}$

$I_{C21}$

13

$U_L$    17    f1

$C_B$    15

18

$I_{CM1}$    19

$U_{CM1}$

23    $R_I$    30

24

14

f2

29    $U_{Q2}$

$U_{LM}$    25

22a

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03012870 A